# EUROPEAN PATENT APPLICATION

(11) **EP 4 700 992 A1**
(43) Date of publication of application: **25.02.2026**
(21) Application number: 24306387.2
(22) Date of filing: 22.08.2024
(51) Int. Cl.: H01R 9/24, H01R 4/36

(54) **CONNECTOR COMPRISING A CAGE SLIDABLY MOUNTED BETWEEN A RETRACTED POSITION AND A DEPLOYED POSITION**

(71) Applicant: Tyco Electronics France SAS, 95300 Pontoise (FR)
(72) Inventor: FRANCE, Philippe, 95300 PONTOISE (FR); MOINE, Geoffrey, 69009 LYON (FR)
(74) Representative: Germain Maureau

(57) **Abstract**

Connector (1) comprising an insulating frame (3) and at least one cage (5) slidably mounted on a corresponding guide (7) of the insulating frame (3) between a retracted position and a deployed position according to an insertion axis (9), wherein the cage (5) includes a releasable clamping part (11) arranged to maintain in deployed position a cooperation between a conductive bar (13) and a wire (15), the guide (7) presenting a contact location (17) extending according to the insertion axis (9) for receiving an extremity portion of the wire (15) when said wire (15) cooperates with the conductive bar (13), and wherein the cage (5) is, in retracted position, out of a zone extending along the contact location (17) according to the insertion axis (9).

## Description

### Field of the invention

The present invention concerns a connector comprising a cage slidably mounted between a retracted position and a deployed position.

### Prior art

It is known to have a connector for linking conductive bars with wires. In a three-phase assembly, the connector can be configured to link three conductive bars to three corresponding wires.

Usually, the bar and the wire are extending according to an identical axis, the insertion axis, and are introduced within the connector from opposed sides of the connector according to said insertion axis.

Such a connector can be located in an electrical cabinet, for example comprising both power and control elements. An example of such an electrical cabinet is a variable speed drive for electric motors.

In this context, the connector is installed within the cabinet and the conductive bars are originally fixed to the connector as they are designed to be connected to wires when installing the electrical cabinet on site.

The wires should then be installed by a technician on site where the electrical cabinet will be used. Such a connector can be a power connector configured to be connected to wires which are relatively big and with a little flexibility.

To simplify the connection of the wires by the technician, there must be sufficient space to insert the cables within their respective contact location with the conductive bars.

However, leaving a free space within the electrical cabinet is not advantageous and there is a need for another solution to help connecting the wires without bending them too much.

Indeed, as evoked above, the cables are not really flexible and inserting them within their contact locations can become difficult.

Some solutions have been proposed to liberate sufficient space for placing the wires at their contact location by using clamping assemblies with moving parts.

However, these clamping assemblies are often made of a large number of parts which implies a difficulty to manufacture them.

Such clamping assemblies can also be difficult to handle, for example for fixing the wires to the corresponding conductive bars after having placed the wires.

The present invention aims to solve all or some of the disadvantages mentioned above.

### Summary of the invention

For this purpose, the present invention relates to a connector comprising an insulating frame and at least one cage slidably mounted on a corresponding guide of the insulating frame between a retracted position and a deployed position according to an insertion axis,
wherein the cage includes a releasable clamping part arranged to maintain in deployed position a cooperation between a conductive bar and a wire, the guide presenting a contact location extending according to the insertion axis for receiving an extremity portion of the wire when said wire cooperates with the conductive bar, and
wherein the cage is, in retracted position, out of a zone extending along the contact location according to the insertion axis.

In other words, the wire is arranged to be installed in the contact location to cooperate with the conductive bar. As in retracted position the cage is no more at the level forecasted for the wire according to the insertion axis, it becomes easier to place and to withdraw the extremity portion of the wire.

The contact location corresponds to a space planned for the extremity portion of the wire. The contact location extends according to the insertion axis. Consequently, the wire can be installed so that it extends according to the insertion axis at least at the level of its extremity portion and in an adjacent portion.

The insertion axis therefore corresponds to a direction according which the wire is introduced within the guide, said guide also extending according to the insertion axis.

According to an aspect of the invention, each cage comprises two lugs or notches that are opposed transversally to the insertion axis and that are configured to cooperate with complementary ribs or grooves of the guide formed in the insulating frame and that are extending in parallel to the insertion axis.

This implies that each cage is designed to cooperate with the guide according to a form complementary cooperation. According to an aspect of the invention, the insulating frame is obtained by molding and is constituted of a plastic material.

This complementarity of form and the fact that the entirety of the cage is in a metal material adapted for joining the corresponding wire and conductive bar enable an ease of movement of the cage between the retracted position and the deployed position.

According to an aspect of the invention, the guide includes end position stops that extend transversally to the insertion axis for limiting the displacement of the cage between the retracted position and the deployed position.

According to an aspect of the invention, each cage is provided with a main through opening extending according to the insertion axis, the main through opening being sized for the insertion of both the corresponding wire and conductive bar within.

The displacement of the cage between the retracted position and the deployed position is designed to facilitate the positioning of the wire in its contact location knowing that the conductive bar is previously present.

The cage can therefore move between the retracted position and the deployed position when the conductive bar is present and ready to cooperate with the wire.

According to an aspect of the invention, the main through opening presents a flat face extending according to the insertion axis and configured to cooperate with the conductive bar in deployed position when the releasable clamping part maintains the cooperation between a conductive bar and a wire.

This feature assures a tight fit between the wire and the conductive bar. Moreover, as the conductive bar is designed to remain within the main through opening between the retracted position and the deployed position, this complementarity of form helps the displacement of the cage.

According to an aspect of the invention, each guide includes a fixation assembly for the corresponding conductive bar so that an extremity of the conductive bar extends in and beyond the main through opening according to the insertion axis in deployed position.

This provision improves the electrical contact between the wire and the conductive bar, the latter being maintained in position by the fixation assembly so that there is enough contact surface between the wire and the conductive bar.

According to an aspect of the invention, each fixation assembly includes a fixation screw and a corresponding threaded hole made in the insulating frame. The conductive bar presents a fixation hole for the passage of said fixation screw to be fixed to the insulating frame.

The conductive bar presents a flat form extending mainly according to the insertion axis, some bending could be realized to adapt to the geometry of the insulating frame. Here, some portions of the conductive bar extends perpendicular to the insertion axis between the fixation assembly and the guide to be inserted at the right level within the guide.

The position of the threaded hole defines the length of the conductive bar extending within the guide. The geometry of the conductive bar is then defined in relationship with the geometry of the insulating frame and the corresponding cage.

According to an aspect of the invention, the main through opening presents a rounded or «U» shaped face extending according to the insertion axis and configured for the insertion of the wire was previously placed in the contact location, when moving the corresponding cage from the retracted position to the deployed position.

The rounded or "U" shaped face is not designed to cooperate with the wire. It should be dimensioned so that the wire can be inserted within the main through opening.

The hollow form of the rounded or "U" shaped face is opposed to the flat face so as to visually guide a user for positioning the wire correctly in the contact location.

In practice, when the cage is in retracted position and the conductive bar is already fixed to the insulating frame, the user position the wire on the conductive bar and then displace the cage to the deployed position so that the wire enters into the main through opening.

It then appears that the cable can have different conductive tips and still be able to be used with the connector. The conductive tip however is usually not without ferrule because the contact with the conductive bar would be of a bad quality and it would be difficult to maintain it in position with the releasable clamping part.

The conductive tip is for example flexible with an insulated ferrule, with a rigid solid ferrule or with a rigid stranded end. Any other relatively rigid end would also work.

The end of the wire including the conductive tip can be installed in the contact location without either being bent by inserting it according to the insertion axis or by translating it perpendicularly to the insertion axis if there is a free space above the contact location.

According to an aspect of the invention, the releasable clamping part is a cylindrical screw adapted to cooperate with a threaded through opening made in the cage transversally to the insertion axis and joining the main through opening, said cylindrical screw having a flat cooperation end arranged to press on the wire to maintain a cooperation between the wire and the conductive bar in deployed position.

The wire and the conductive bar are clamped between the flat face and the flat cooperation end when the cylindrical screw is lowered within the cage. The cylindrical screw comprises also a cooperating part for a tool as a screwdriver or a hexagonal key.

According to an aspect of the invention, the insulating frame comprises a base and walls extending from the base, each guide being formed by an upper surface of the base and two walls extending transversally to the upper surface.

Two consecutive guides share a common wall. Each guide thus presents a general "U" shaped form with right angles. This corresponds to the general form of the cage which is a protrusion with a rectangle or squared basis extending according to the insertion axis.

The form of the guide creates a free space in front of the upper surface, this free space facilitated the positioning of the wire in the contact location when the cage is in retracted position.

According to an aspect of the invention, there are four walls creating three guides for three wire-conductive bar connections. Preferably, the connector is adapted for a power transmission wherein the wires have a diameter implying a difficulty to bend them manually.

Alternatively, the connector is also adapted for signal or command wires and could useful in limited spaces.

According to an aspect of the invention, the base has holes for fixing screws to install the connector on a support.

The present invention also concerns an electrical cabinet comprising at least one connector as described above, wherein the electrical cabinet also includes at least one wire and at least one conductive bar, said conductive bar being bar of an electrical device of the electrical cabinet.

According to an aspect of the invention, the electrical cabinet is an automation frequency converter or variable speed drive for electric motors.

The different aspects defined above that are not incompatible can be combined.

### Brief description of the figures

The invention will be better understood with the aid of the detailed description that is set out below with reference to the appended drawing in which:
- figure 1 is a perspective view of a connector with cages in deployed position;
- figure 2 is a perspective view of the connector with the cages in retracted position;
- figure 3 is a front view of a part of an electrical cabinet including two connectors with their cages in deployed position;
- figure 4 is a perspective view of the connector with the cages in deployed position;
- figure 5 is a perspective view of the connector with a central cage in deployed position and the two other cages in retracted position;
- figure 6 is a perspective view of a bottom of the connector to be fixed to the electrical cabinet.

### Description with reference to the figures

In the following detailed description of the figures defined above, the same elements or the elements that are fulfilling identical functions may retain the same references so as to simplify the understanding of the invention.

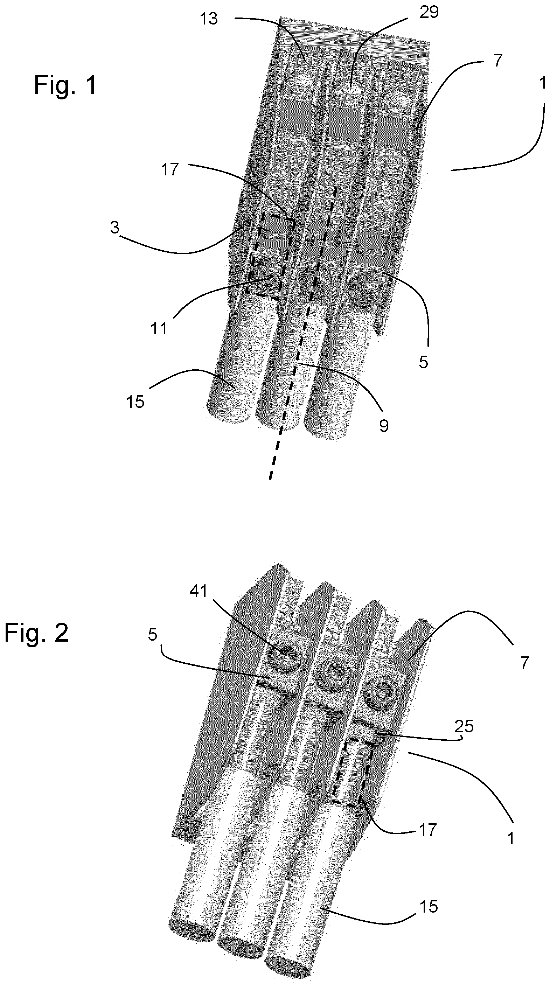

As illustrated in figures 1 to 5, a connector 1 comprises an insulating frame 3 and at least one cage 5 slidably mounted on a corresponding guide 7 of the insulating frame 3 between a retracted position illustrated in figure 2 and a deployed position illustrated in figures 1, 3 and 4 according to an insertion axis 9.

The cage 5 includes a releasable clamping part 11 arranged to maintain in deployed position a cooperation between a conductive bar 13 and a wire 15, the guide 7 presenting a contact location 17 extending according to the insertion axis 9 for receiving an extremity portion of the wire 15 when said wire 15 cooperates with the conductive bar 13.

The cage 5 is, in retracted position, out of a zone extending along the contact location 17 according to the insertion axis 9.

In other words, the wire 15 is arranged to be installed in the contact location 17 to cooperate with the conductive bar 13. As in retracted position the cage 5 is no more at the level forecasted for the wire 15 according to the insertion axis 9, it becomes easier to place and to withdraw the extremity portion of the wire 15.

The contact location 17 corresponds to a space planned for the extremity portion of the wire 15. The contact location 17 extends according to the insertion axis 9. Consequently, the wire 15 can be installed so that it extends according to the insertion axis 9 at least at the level of its extremity portion and in an adjacent portion.

The insertion axis 9 therefore corresponds to a direction according which the wire 15 is introduced within the guide 7, said guide 7 also extending according to the insertion axis 9.

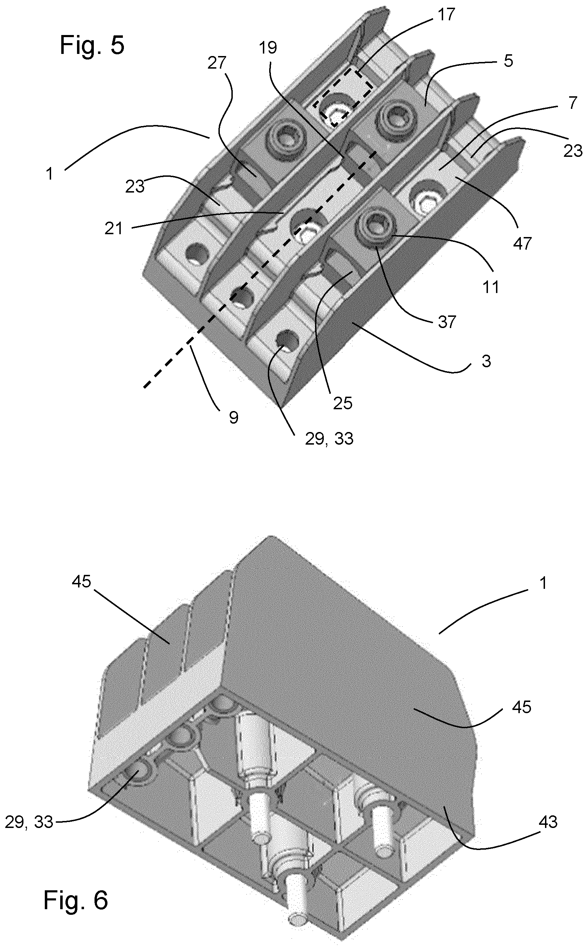

As illustrated in figure 5, each cage 5 comprises two lugs or notches 19 that are opposed transversally to the insertion axis 9 and that are configured to cooperate with complementary ribs or grooves 21 of the guide 7 formed in the insulating frame 3 and that are extending in parallel to the insertion axis 9.

This implies that each cage 5 is designed to cooperate with the guide 7 according to a form complementary cooperation. The insulating frame 3 is obtained by molding and is constituted of a plastic material.

This complementarity of form and the fact that the entirety of the cage 5 is in a metal material adapted for joining the corresponding wire 15 and conductive bar 13 enable an ease of movement of the cage 5 between the retracted position and the deployed position.

The guide 7 includes end position stops 23 that extend transversally to the insertion axis 9 for limiting the displacement of the cage 5 between the retracted position and the deployed position.

Each cage 5 is provided with a main through opening 25 extending according to the insertion axis 9, the main through opening 25 being sized for the insertion of both the corresponding wire 15 and conductive bar 13 within.

The displacement of the cage 5 between the retracted position and the deployed position is designed to facilitate the positioning of the wire 15 in its contact location knowing that the conductive bar 13 is previously present.

The cage 5 can therefore move between the retracted position and the deployed position when the conductive bar 13 is present and ready to cooperate with the wire 15.

The main through opening 25 presents a flat face 27 extending according to the insertion axis 9 and configured to cooperate with the conductive bar 13 in deployed position when the releasable clamping part 11 maintains the cooperation between a conductive bar 13 and a wire 15.

This feature assures a tight fit between the wire 15 and the conductive bar 13. Moreover, as the conductive bar 13 is designed to remain within the main through opening 25 between the retracted position and the deployed position, this complementarity of form helps the displacement of the cage 5.

Each guide 7 includes a fixation assembly 29 for the corresponding conductive bar 13 so that an extremity of the conductive bar 13 extends in and beyond the main through opening 25 according to the insertion axis 9 in deployed position.

This provision improves the electrical contact between the wire 15 and the conductive bar 13, the latter being maintained in position by the fixation assembly 29 so that there is enough contact surface between the wire 15 and the conductive bar 13.

Each fixation assembly 29 includes a fixation screw 31 and a corresponding threaded hole 33 made in the insulating frame 3. The conductive bar 13 presents a fixation hole for the passage of said fixation screw 31 to be fixed to the insulating frame 3.

The conductive bar 13 presents a flat form extending mainly according to the insertion axis 9, some bending could be realized to adapt to the geometry of the insulating frame 3. Here, some portions of the conductive bar 13 extends perpendicular to the insertion axis 9 between the fixation assembly 29 and the guide 7 to be inserted at the right level within the guide 7.

The position of the threaded hole 33 defines the length of the conductive bar 13 extending within the guide 7. The geometry of the conductive bar 13 is then defined in relationship with the geometry of the insulating frame 3 and the corresponding cage 5.

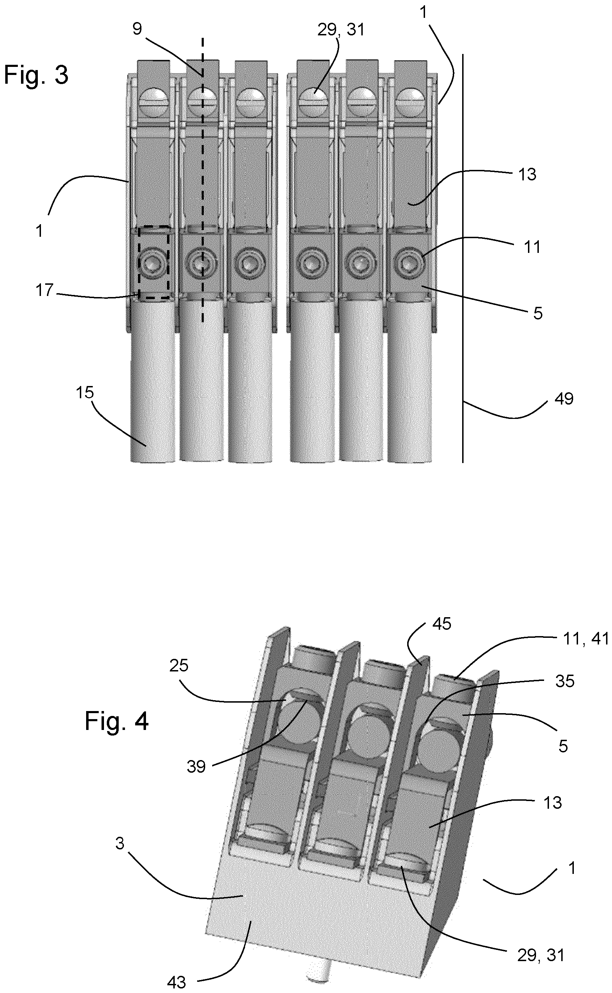

As illustrated in figure 4, the main through opening 25 presents a rounded or "U" shaped face 35 extending according to the insertion axis 9 and configured for the insertion of the wire 15 was previously placed in the contact location 17, when moving the corresponding cage 5 from the retracted position to the deployed position.

The rounded or «U» shaped face 35 is not designed to cooperate with the wire 15. It should be dimensioned so that the wire 15 can be inserted within the main through opening 25.

The hollow form of the rounded or «U» shaped face 35 is opposed to the flat face 27 so as to visually guide 7 a user for positioning the wire 15 correctly in the contact location 17.

In practice, when the cage 5 is in retracted position and the conductive bar 13 is already fixed to the insulating frame 3, the user position the wire 15 on the conductive bar 13 and then displace the cage 5 to the deployed position so that the wire 15 enters into the main through opening 25.

It then appears that the cable can have different conductive tips and still be able to be used with the connector 1. The conductive tip however is usually not without ferrule because the contact with the conductive bar 13 would be of a bad quality and it would be difficult to maintain it in position with the releasable clamping part 11.

The conductive tip is for example finely stranded or rigid stranded with an insulated ferrule or solid end. Any other relatively rigid end would also work.

The end of the wire 15 including the conductive tip can be installed in the contact location 17 without either being bent by inserting it according to the insertion axis 9 or by translating it perpendicularly to the insertion axis 9 if there is a free space above the contact location 17.

The releasable clamping part 11 is a cylindrical screw adapted to cooperate with a threaded through opening 37 made in the cage 5 transversally to the insertion axis 9 and joining the main through opening 25, said cylindrical screw having a flat cooperation end 39 arranged to press on the wire 15 to maintain a cooperation between the wire 15 and the conductive bar 13 in deployed position.

The wire 15 and the conductive bar 13 are clamped between the flat face 27 and the flat cooperation end 39 when the cylindrical screw is lowered within the cage 5. The cylindrical screw comprises also a cooperating part 41 for a tool as a screwdriver or a hexagonal key.

The insulating frame 3 comprises a base 43 and walls 45 extending from the base 43, each guide 7 being formed by an upper surface 47 of the base 43 and two walls 45 extending transversally to the upper surface 47.

Two consecutive guides 7 share a common wall 45. Each guide 7 thus presents a general "U" shaped form with right angles. This corresponds to the general form of the cage 5 which is a protrusion with a rectangle or squared basis extending according to the insertion axis 9.

The form of the guide 7 creates a free space in front of the upper surface 47, this free space facilitated the positioning of the wire 15 in the contact location 17 when the cage 5 is in retracted position.

There are four walls 45 creating three guides 7 for three wire 15-conductive bar 13 connections. The connector 1 is adapted for a power transmission wherein the wires 15 have a diameter implying a difficulty to bend them manually.

Alternatively, the connector 1 is also adapted for signal or command wires 15 and could useful in limited spaces.

As illustrated in figure 6, the base 43 has holes for fixing screws to install the connector 1 on a support.

As illustrated in figure 3, there is an electrical cabinet 49 comprising two connectors 1 as described above, wherein the electrical cabinet 49 also includes at least one wire 15 and at least one conductive bar 13, said conductive bar 13 being bar of an electrical device of the electrical cabinet 49.

The electrical cabinet 49 can be an automation frequency converter or variable speed drive for electric motors.

It thus appears that the connector 1 enables an easy installation of the wire 15 even when there is not so much space at disposal. When the cage 5 is in retracted position, there is no need to bend the wire 15 for plugging it.

As goes without saying, the invention is not limited to the sole embodiment described above by way of example, it encompasses all the variants.

## Claims

1. Connector (1) comprising an insulating frame (3) and at least one cage (5) slidably mounted on a corresponding guide (7) of the insulating frame (3) between a retracted position and a deployed position according to an insertion axis (9),
wherein the cage (5) includes a releasable clamping part (11) arranged to maintain in deployed position a cooperation between a conductive bar (13) and a wire (15), the guide (7) presenting a contact location (17) extending according to the insertion axis (9) for receiving an extremity portion of the wire (15) when said wire (15) cooperates with the conductive bar (13), and
wherein the cage (5) is, in retracted position, out of a zone extending along the contact location (17) according to the insertion axis (9).

2. Connector (1) according to claim 1, wherein each cage (5) comprises two lugs or notches (19) that are opposed transversally to the insertion axis (9) and that are configured to cooperate with complementary ribs or grooves (21) of the guide (7) formed in the insulating frame (3) and that are extending in parallel to the insertion axis (9).

3. Connector (1) according to one of the claims 1 or 2, wherein each cage (5) is provided with a main through opening (25) extending according to the insertion axis (9), the main through opening (25) being sized for the insertion of both the corresponding wire (15) and conductive bar (13) within.

4. Connector (1) according to claim 3, wherein the main through opening (25) presents a flat face (27) extending according to the insertion axis (9) and configured to cooperate with the conductive bar (13) in deployed position when the releasable clamping part (11) maintains the cooperation between a conductive bar (13) and a wire (15).

5. Connector (1) according to one of the claims 3 or 4, wherein each guide (7) includes a fixation assembly (29) for the corresponding conductive bar (13) so that an extremity of the conductive bar (13) extends in and beyond the main through opening (25) according to the insertion axis (9) in deployed position.

6. Connector (1) according to one of the claims 3 to 5, wherein the main through opening (25) presents a rounded or «U» shaped face (35) extending according to the insertion axis (9) and configured for the insertion of the wire (15) was previously placed in the contact location (17), when moving the corresponding cage (5) from the retracted position to the deployed position.

7. Connector (1) according to one of the claims 1 to 6, wherein the releasable clamping part (11) is a cylindrical screw adapted to cooperate with a threaded through opening (37) made in the cage (5) transversally to the insertion axis (9) and joining the main through opening (25), said cylindrical screw having a flat cooperation end (39) arranged to press on the wire (15) to maintain a cooperation between the wire (15) and the conductive bar (13) in deployed position.

8. Connector (1) according to one of the claims 1 to 7, wherein the insulating frame (3) comprises a base (43) and walls (45) extending from the base (43), each guide (7) being formed by an upper surface (47) of the base (43) and two walls (45) extending transversally to the upper surface (47).

9. Electrical cabinet (49) comprising at least one connector (1) according to one of claims 1 to 8, wherein the electrical cabinet (49) also includes at least one wire (15) and at least one conductive bar (13), said conductive bar (13) being bar of an electrical device of the electrical cabinet (49).

10. Electrical cabinet (49) according to claim 9, being an automation frequency converter or variable speed drive for electric motors.
